# EUROPEAN PATENT APPLICATION

(11) **EP 0 788 164 A1**
(43) Date of publication of application: **06.08.1997**
(21) Application number: 96630046.9
(22) Date of filing: 12.08.1996
(51) Int. Cl.: H01L 27/108, H01L 21/8242

(54) **Memory cell configuration for increased capacitor area**

(30) Priority: 02.02.1996 US 595755
(71) Applicant: UNITED MEMORIES, INC., Colorado Springs, CO 80919 (US); Nippon Steel Semiconductor Corp., Tateyama-shi, Chiba 294 (JP)
(72) Inventor: Butler, Douglas B., Colorado Springs, Colorado 80919 (US)
(74) Representative: Waxweiler, Jean

(57) **Abstract**

A capacitor for use as a part of a memory cell, such as a DRAM, constructed according to design rules of 0.4µm, or less. The capacitor includes a cross-shaped capacitor electrode (50) connected to a memory transistor of the DRAM and may overlie bit lines (57) of the DRAM to provide a COB array. An insulation layer (52) overlies the memory transistor (56), and the cross-shaped capacitor electrode (50) in turn overlies the insulation layer. A dielectric layer (62) and a conformal capacitor electrode (60) are arranged with respect to the cross-shaped capacitor electrode to complete the capacitor. The cross-shaped capacitor electrode may be dimensioned to be about 0.2µm, or more, thick, 1.6µm long, 1.6µm wide, with each arm of the cross-shaped electrode about 0.4µm wide, wherein the lateral sides of the electrode contribute to a surface area of the capacitor electrode to increase the capacitance of the capacitor in which it is included.

## Description

### BACKGROUND OF THE INVENTION

### 1. FIELD OF THE INVENTION

This invention relates to improvements in memory cell layouts, and more particularly to improvements in configurations for memory capacitor electrodes, and still more particularly to improvements in the configuration of memory capacitor electrodes to increase the capacitor area, and to methods for making same.

### 2. BACKGROUND INFORMATION

Memory cells have become smaller with each generation of DRAM. However, the amount of charge storage needed for reliable operation has not decreased as rapidly. This has resulted in a need for techniques that increase the capacitance of memory cell capacitors. One technique which has been used is to configure the capacitor plates so that one plate partially overlies an adjacent plate in a planner manner. The second plates for the capacitor structure, however, must interdigitate with the first plates, and requires an unattractively complex process.

Another technique that has been employed to increase the capacitance of capacitor electrodes in memory structures has been to provide a three-dimensional structure with vertical fins at the perimeter of the electrode. Such three-dimensional structures are useful in increasing the surface area of the capacitor with which it is used with respect to the overall area on which the capacitor is fabricated.

Still another technique is to provide a surface roughness on one or both sides of the capacitor plate. Finally, various materials having high dielectric constants have been employed to increase the capacitance of the capacitor structures. It is apparent that many of the various techniques that have been used may sometimes be used in conjunction other techniques. Nevertheless, additional improvement can be beneficial.

One general technique or capacitor structure that has been proposed is a "capacitor over bit line" cell (COB). This cell allows the capacitor to overlie the entire cell area since no bit line contact needs to be made to the cell. Using a COB cell, the area of the memory cell capacitor can be as large as the length of the cell multiplied by the width of the cell, minus the area necessary to separate adjacent cells. For example, first generation 16 megabit DRAMS had cell sizes of about 1.5µm X 3.0µm, and were designed for processes with 0.6µm design rules. A COB capacitor area then could be (1.5µm - 0.6µm) X (3.0µm - 0.6µm) = 2.16µm². If space needs to be made to allow a bit line contact (assuming a ½ pitch cell), the area of the COB cell is reduced to about (1.5µm - 0.6µm) X (3.0µm - 0.9µm) = 1.89µm². Thus, the use of a COB cell enables an increase in capacitor area to be realized on the order of about 14% ((2.16/1.89) = 1.14).

As memory cell sizes have shrunk to dimensions close to the thickness of materials from which memory cell electrodes are fabricated, the amount of capacitance contributed by the lateral edges along the perimeter of the capacitor electrode has become relatively more important. For example, in a 1.5µm X 3.0µm 16 Megabit COB cell, if the capacitor electrode layer is 0.2µm thick, the electrode sidewall area of that cell would be ((3.0µm - 0.6µm) + (1.5µm - 0.6µm)) X 2 X 0.2µm = 1.32µm².

This trend is continuing as design rules are decreased. For example, a first generation 64 Megabit DRAM cell is about 1.0µm X 2.0µm, using a 0.4µm design rule process. Using a COB cell, the capacitor area would be (1.0µm - 0.4µm) X (2.0µm - 0.4µm) = 0.96µm². With 0.2 µm thick electrodes, the sidewall area would be (0.6µm + 1.6µm) X 2 X 0.2µm = 0.88µm². It can be seen that at design rules below ½µm, the sidewall area becomes almost as important a consideration as the surface area (herein referred to as the "planar" area) of the capacitor electrode.

Traditional memory cell layout has focused on maximizing the planar area of the capacitor. For design rules in the range of 0.4µm, and less, it is more important to maximize the sidewall area, which means that the perimeter of the capacitor electrode needs to be maximized.

One way to maximize the perimeter while keeping the total memory cell area constant is to increase the cell length, while decreasing the cell width. For a COB cell with a 2µm² total area, 0.2µm electrode thickness, and 0.4µm design rules, as discussed above, the following cell sizes, electrode planar areas, and sidewall areas are:

**TABLE I**

| Cell Area | Cell Length | Cell Width | Planar Area | S/Wall Area | Total Area |
|---|---|---|---|---|---|
| 2.00 | 2.00 | 1.00 | 0.96 | 0.88 | 1.84 |
| 2.00 | 1.41 | 1.41 | 1.02 | 0.81 | 1.83 |
| 2.00 | 2.50 | 0.80 | 0.84 | 1.00 | 1.84 |

The width of the cell must be at least 0.8µm to allow for a 0.4µm electrode width and spaces to adjacent electrodes so that the minimum design rules are not violated. It should be noted that the total area is almost constant for the assumed 0.2µm electrode thickness.

### SUMMARY OF THE INVENTION

In light of the above, therefore, it is an object of the invention to provide an improved memory cell layout for increasing the area of a memory cell capacitor conductor.

It is another object of the invention to provide an improved DRAM memory cell.

It is yet another object of the invention to provide an improved capacitor for use in a DRAM cell, which is constructed with design rules of 0.4µm, or less.

It is still another object of the invention to provide an improved memory cell array.

It is yet another object of the invention to provide an improved capacitor layout for a memory cell array.

It is another object of the invention to provide an improved method for making memory cell capacitors in an array to assure that the capacitor electrodes of adjacent cells do not touch.

These and other objects, features, and advantages will be apparent to those skilled in the art from the following detailed description, when read in conjunction with the accompanying drawings and appended claims.

In accordance with a broad aspect of the invention, a capacitor for use as a part of a DRAM is presented. The capacitor includes a cross-shaped capacitor electrode connected to the DRAM and overlying an insulation layer over the DRAM. The cross-shaped capacitor electrode may be dimensioned to be about 0.2µm, or more, thick, 1.6µm long, 1.6µm wide, with each arm of the cross-shaped electrode being about 0.4µm wide. A dielectric layer and substantially conformal conductor are arranged in relation to the cross-shaped capacitor electrode to provide the capacitor for use as a part of the DRAM. The capacitor may be, for example, located over a bit line of the DRAM to provide a COB memory array.

According to another broad aspect of the invention, a capacitor for use with a semiconductor memory cell is presented. The capacitor includes a cross-shaped capacitor electrode overlying an insulation layer over the memory cell. The cross-shaped electrode may be about 0.2µm, or more, thick, 1.6µm long, 1.6µm wide, with each arm of the electrode about 0.4µm wide. A substantially conformal conductor and capacitor dielectric form the capacitor in conjunction with the cross-shaped electrode.

According to yet another broad aspect of the invention, a capacitor for use with a semiconductor memory transistor is presented. In one embodiment, the capacitor has one electrode with at least two crossed members; in another embodiment, the capacitor electrode has a shape like a "+" sign; and in yet another embodiment, the capacitor electrode is cross-shaped. The cross-shaped capacitor may be about 0.2µm, or more, thick, 1.6µm long, and 1.6µm wide, with each arm of the electrode being about 0.4µm wide.

According to still yet another broad aspect of the invention, a DRAM is presented. The DRAM includes a semiconductor substrate and a memory transistor in the semiconductor substrate. The DRAM includes a capacitor having one electrode configured to have more than four lateral sides, the lateral sides contributing to a surface area of the capacitor electrode. In one embodiment, the capacitor electrode has at least too crossed members, in another embodiment, the capacitor electrode has a shape like a "+" sign, and in yet another embodiment, the capacitor electrode is cross-shaped. The cross-shaped capacitor may be about 0.2µm, or more, thick, 1.6µm long, and 1.6µm wide, with each arm of the electrode being about 0.4µm wide.

According to yet another broad aspect of the invention, a memory array is presented in a semiconductor substrate in which a plurality of memory cells are constructed. Each memory cell has a memory transistor and a capacitor, and each capacitor includes a capacitor electrode having more than four lateral sides, the lateral sides contributing to a surface area of the capacitor electrode. In one embodiment, the capacitor electrode has the shape of a "+" sign, and in another embodiment, the capacitor electrode is cross-shaped. The cross-shaped electrode may be about 0.2µm, or more, thick, 1.6µm long, 1.6µm wide, with each arm of the cross-shaped electrode being about 0.4µm wide.

In yet another broad aspect of the invention, a method for making a capacitor electrode is presented in which a mask is provided that has contiguous capacitor electrode features to be transferred to a positive photoresist layer in a semiconductor manufacturing process. The positive photoresist layer is then overexposed using the mask so that the contiguous capacitor electrode features do not touch when the positive photoresist is developed.

### BRIEF DESCRIPTION OF THE DRAWING

The invention is illustrated in the accompanying drawings, in which:
Figure 1 is a top elevational view of a portion of a plurality of memory cells, showing a typical arrangement of cross-shaped capacitor electrodes, according to a preferred embodiment of the invention.
Figure 2 is a top elevational view of a portion of a "COB" memory array constructed using a plurality of cross-shaped memory capacitor electrode elements, partially cut away to show the relationship of the electrode elements to the underlying word and bit lines, according to a preferred embodiment of the invention.
Figure 3 is a top elevational view of a portion of a memory array constructed using a plurality of cross-shaped memory capacitor electrode elements, according to a preferred embodiment of the invention, showing the locations of connections between the memory capacitor elements and bit lines to the underlying memory elements, using a ¼ pitch cell arrangement.
Figure 4 is a cross section drawing taken at 2-2 in Figure 3, showing the interconnections between the memory capacitor elements to the underlying memory elements, according to a preferred embodiment of the invention.
Figure 5 is a cross section drawing taken at 2-2 in Figure 3, showing the interconnections between the bit lines to the underlying memory elements, according to a preferred embodiment of the invention.
Figure 6a is a top elevational view of a portion of a mask used in creating patterns in photosensitive areas during semiconductor manufacturing processes.
Figure 6b is a top elevational view of a portion of an integrated circuit feature created using the mask pattern of Figure 6a, in which the photoresist or other photosensitive layer used in the manufacturing process has been underexposed.
Figure 6c is a top elevational view of a portion of an integrated circuit feature created using the mask pattern of Figure 3a, in which the photoresist or other photosensitive layer used in the manufacturing process has been properly exposed.
Figure 6d is a top elevational view of a portion of an integrated circuit feature created using the mask pattern of Figure 3a, in which the photoresist or other photosensitive layer used in the manufacturing process has been overexposed, in accordance of a preferred embodiment of the method of the invention.
Figure 7 is a top elevational view of a portion of a memory array constructed using the photoresist over exposure techniques illustrated in Figures 6d to assure noncontact between adjacent capacitor electrode elements, according to a preferred embodiment of the invention, also showing the locations of connections between the memory capacitor elements and bit lines to the underlying memory elements, using a ¼ pitch cell arrangement.
Figure 8 is a top elevational view of a portion of a non-COB memory array constructed using a plurality of cross-shaped memory capacitor electrode elements, showing additionally connections made to the memory capacitor elements using a ¼ pitch cell arrangement, according to another preferred embodiment of the invention.

In the various figures of the drawing, like reference numerals are used to denote like or similar parts.

### DETAILED DESCRIPTION OF THE PREFERRED EMBODIMENTS

It should be noted that the process steps and structures herein described do not necessarily form a complete process flow for manufacturing integrated circuits. It is anticipated that the present invention may be practiced in conjunction with integrated circuit fabrication techniques currently used in the art, and only so much of the commonly practiced process steps are included as are necessary for an understanding of the present invention.

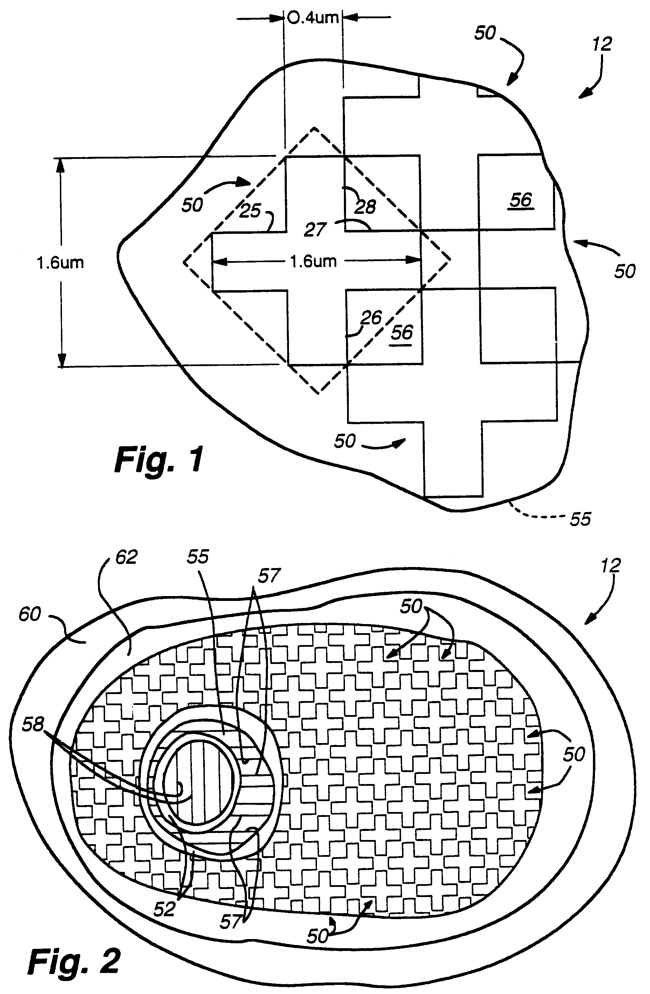

A preferred embodiment of the invention is shown in Figures 1 - 5, to which reference is now made. Figure 1 shows a top elevational view of a portion of several adjacent capacitor electrodes 50 of a DRAM array 12. In the embodiment illustrated, each of the capacitor electrodes 50 is patterned in the shape of a cross or "+" shape to address the need to maximize the area provided by the lateral side wall portions of the capacitor electrode or conductor. It will be appreciated that since one goal of the invention is to increase the perimeter and, therefore, the surface area of the capacitor electrode, in addition to the cross or "+" shaped electrodes, other electrode configurations may be employed. Those skilled in the art, therefore, will readily appreciate the application of the principles of the invention to the realization of capacitor electrodes of multi-armed shapes, star shapes, or other configurations having plural "arms" with multiplied lateral side wall areas contributing to the overall area of the capacitor element.

For example, in the embodiment shown, each capacitor electrode 50 has four outwardly extending arms 25 - 28, dimensioned, for instance, for use in an array following 0.4µm design rules, with the arms of the electrode being 0.4µm in width and 1.6µm in length. The thickness may be greater than or equal to 50% of the width of one of the arms, and, more particularly, may be 0.2µm, 0.28µm, or more. The area of the capacitor electrode constructed in the manner shown in Figure 1 are compared to the areas shown in Table I above, as follows:

**Table II**

| Cell Area (µm²) | Cell Length (µm) | Cell Width (µm) | Planar Area (µm²) | S/Wall Area (µm²) | Total Area (µm²) |
|---|---|---|---|---|---|
| 2.00 | -- | -- | 1.12 | 1.28 | 2.40 |

It can be seen that a capacitor electrode constructed with the proposed cross-shape has a significantly increased perimeter from previous square and rectangular designs, as demonstrated in Table III below.

**Table III**

| | Cell Size (µm²) | Electrode Area (µm²) | Electrode Perimeter (µm) |
|---|---|---|---|
| Rectangle | 2.00 | 0.96 | 4.40 |
| Cross | 2.00 | 1.12 | 6.40 |
| %Increase | 0% | 17% | 45% |

Although the memory capacitors are described herein primarily in conjunction with DRAM devices and arrays, it should be understood that the memory capacitors may be equally advantageously employed in other types of memory cells and arrays in which a need exists for larger capacitances with decreasing feature sizes. As apparent from the example above, for instance, the cross or "+" sign shape is particularly suitable, for example, for memory capacitors having elements of thickness of about 0.2µm or more, and is particularly well suited for use in processes in which design rules of ½µm, and in particular 0.4µm or less, are employed.

With reference now to Figure 2, a partially cut away memory array 12 is shown illustrating one spatial interrelationship that may be used between the plurality of capacitor electrodes 50 and the underlying bit lines 57 and word lines 58 in the COB memory array 12. Each of the capacitor electrode elements 50 are similarly constructed, overlying a DRAM array in a semiconductor substrate 55, which may be, for example, P type silicon, or other suitable semiconductor material.

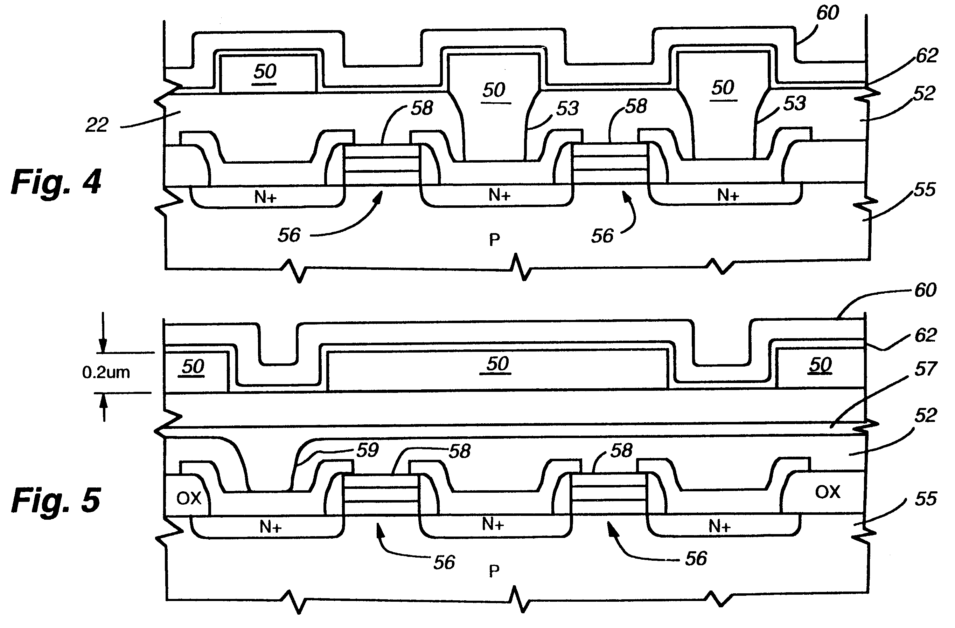

In the embodiment illustrated, word lines 58 are arranged vertically, and the bit lines 57 are arranged horizontally over the DRAM array. The bit lines are insulated from the word lines 58 and other memory transistor elements in the substrate 55 by a layer of insulation 52 in which the bit lines are contained. The layer of insulation 52 also insulates the memory elements 56 (see Figure 5) from the bit lines 57.

A capacitor dielectric 62 separates the capacitor electrodes 50 from a substantially conformal conductive layer 60, for example of metal or, preferably, polysilicon formed over the entire structure. The conductive layer 60 serves as the top conductor for the memory capacitors 56, in conjunction with the individual capacitor electrodes 50. The dielectric layer 62, therefore, provides the capacitor dielectric, which may be a conventional dielectric material, such as silicon oxide, or a more exotic dielectric material, such as tantalum oxide, or the like. A layer of BPSG or other suitable material (not shown) may be formed over the entire structure.

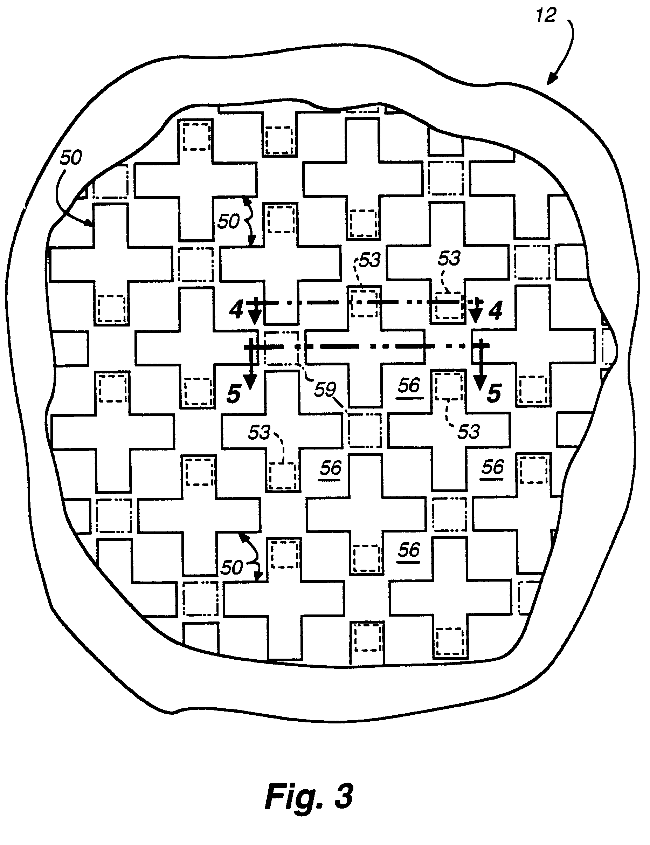

With the construction of the capacitor electrode elements 50 illustrated, with reference now to Figure 3, one arrangement for the various contacts to connect the various capacitor elements 50 and bit lines 57 to the underlying memory transistors 56 is shown. As shown, a plurality of memory transistor contacts 59 and 53 are connected between the memory transistors 56 and, respectively, various capacitor elements 50 and bit lines 57. (The capacitor electrode to memory transistor contacts 53 are shown, for purposes of illustration, having a dashed line outline to distinguish them from the dash-dot bit-line to memory transistor contacts 59.)

It can be seen that by virtue of the particular arrangement illustrated, a contact is provided for each capacitor electrode 50. The memory array 12 is constructed, in the embodiment shown in Figure 3, with ¼ pitch cells. The use of a ¼ pitch cells assures that each cross-shaped capacitor electrode 50 will properly align with a cell contact 53, as shown. A ¼ pitch cell having dimensions of 1.0 µm X 2.0 µm occupies the same area as it would for a ½ pitch cell.

As best seen in Figures 4 and 5, which are cross-sectional views of the COB array structure of Figure 3 taken respectively at 4 - 4 and 5 - 5, the insulating layer 52 is formed over the surface of the substrate 55 in which memory transistors 56 have been formed. The dielectric layer 52, may be, for example, silicon oxide, or other suitable insulating material. The capacitor electrodes 50 are patterned over the insulating later 52, and are connected to drain regions of respective memory transistors 56, best seen in Figure 4. In addition, a number of bit lines 57 are formed within the insulating layer 52 over the substrate 55 along desired paths for connections 59 to source regions of respective underlying memory transistors 56, best seen in Figure 5. The bit lines 57 may be formed by appropriate metalization or polysilicon patterning techniques known in the art. Thus, the memory cell array shown in Figures 1 - 5 provides a plurality of memory cells, which are each diagonally arranged with respect to adjacent or contiguous cells.

It can be seen that when the capacitor electrode elements 50 are made with maximum size in the diagonal cell arrangement illustrated, the corners of the crosses of adjacent cells nearly touch, as shown. Thus, with the electrode elements sized to a maximum extent, a 0.4µm design rule will be violated, since the spacing between capacitor element features will be much less than 0.4µm.

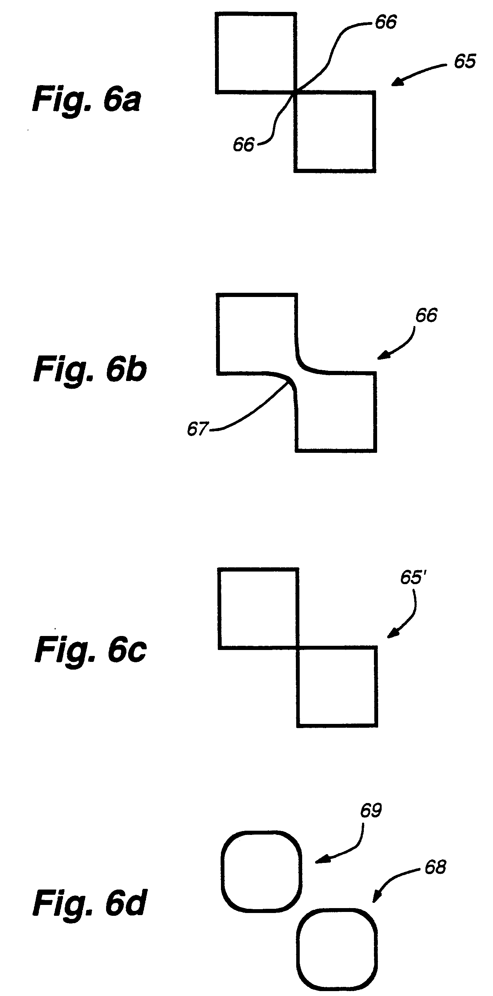

Consequently, according to a preferred embodiment of a method for constructing the capacitor elements 50 of the present invention, with reference now to Figures 6a - 6d, a photoresist exposing and etching technique is employed to construct the capacitor electrodes in an array, which prevents contact between adjacent corners of contiguous capacitor electrodes. More particularly, a stylized square pattern 65 with sharp, rectangular corners 66 is shown in Figure 6a for illustration. The pattern 65 represents a pattern as may be seen in an appropriate photomask used in semiconductor processing, such photomasks being well known in the art.

Typically, in the fabrication of integrated circuit features, a layer of photoresist is applied to a substrate on which the feature, such as the capacitor electrodes described herein, are desired to be formed. The photomask is placed in registration with marks or other alignment indicia on the substrate, and the photoresist layer is exposed through the mask to an appropriate light source, typically using a 5X reduction lens between the mask and photoresist, to polymerize or otherwise physically change the photoresist material. The photoresist is then exposed to chemical processes to leave a pattern on the substrate corresponding to the feature pattern desired to be fabricated.

The structure is then exposed to an etch process in which the material from which the feature is to be constructed is removed from the substrate, and in particular, remains in the pattern defined by the photoresist. The photoresist remaining on the substrate is then removed, leaving the desired featured pattern on the substrate.

During the foregoing process, if the exposure of the photoresist to the light source is "correct" the mask pattern is copied substantially identically into the photoresist, producing, in the case illustrated, the pattern 65' shown in Figure 6c from the mask pattern shown in Figure 6a. On the other hand, assuming a positive photoresist material is used, if the photoresist material is underexposed, the pattern 66 shown in Figure 6b may be formed, with continuous corners undesirably being joined by a bridge or island of material 67. Finally, if the positive photoresist material is over-exposed during the exposure steps in the fabrication process, the sharp corners and edges of the features formed in the photoresist material tend to become rounded or retired from the position, for example, that might be achieved in a properly exposed process. The resulting features, therefore, would be as shown in Figure 6d in which the corners of the rectangular features 68 and 69 are withdrawn from each other, resulting in the features not being in direct electrical contact. Thus, if the photoresist is overexposed, the outside edges of the features are less defined, resulting generally in the corners of the rectangular features being rounded, and particularly in the adjacent corners of neighboring rectangular features not touching.

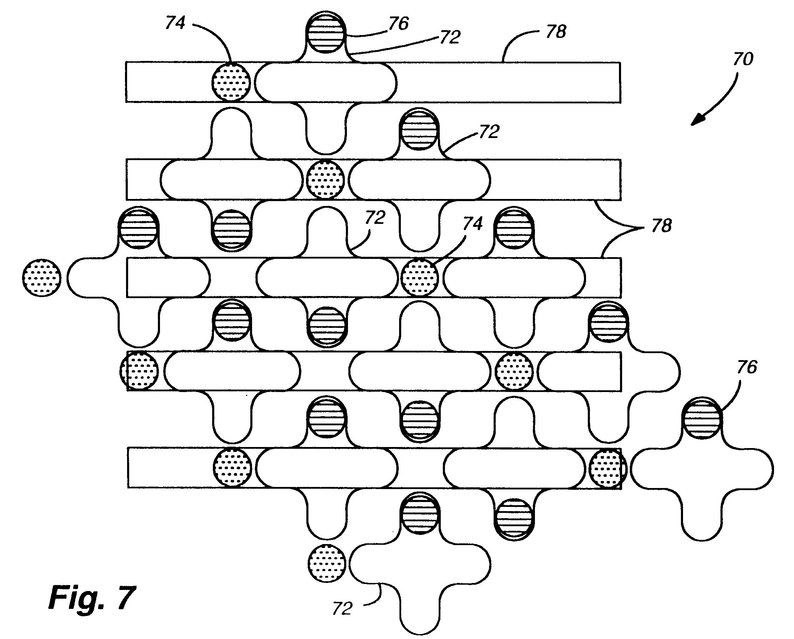

A top elevational view of a portion of a memory array 70, constructed with a plurality of cross-shaped memory capacitor electrode elements 72, is shown in Figure 7. The various respective adjacent corners of the capacitor electrode elements 72, having been formed by the photoresist over exposing process described above, are rounded and not in contact with their adjacent neighbors. As shown, the electrode contacts 74 and 76 are arranged in a diagonal pattern. Contact regions to the underlying memory transistors are shown by the dotted circles 74 and hatched circles 76 to the bit lines 78 and capacitor electrode elements 72, respectively.

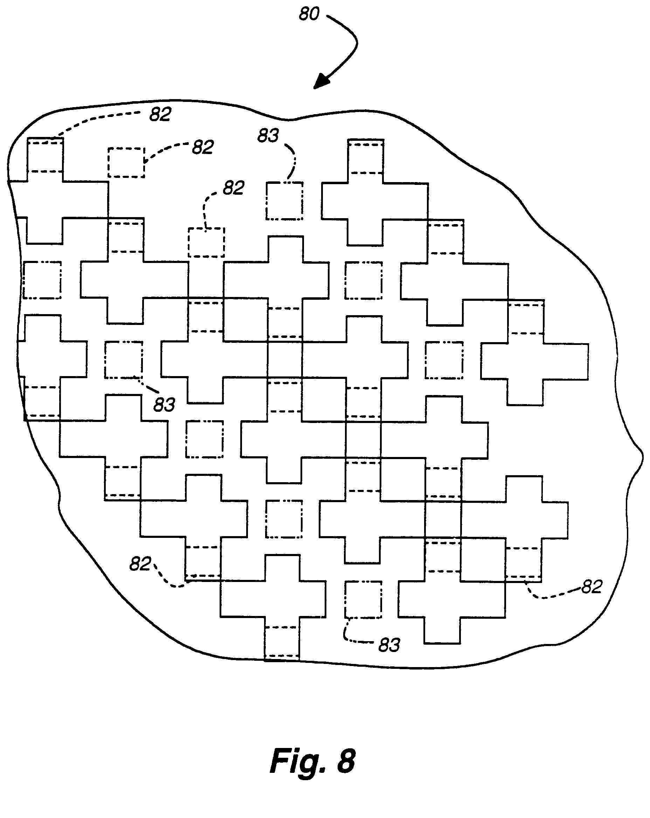

It will be appreciated that three-dimensional types of capacitor structures, such as structure with vertical fins at the perimeter of the electrode described above, can be equally advantageously employed in the construction of the capacitors of the invention. Additionally, the advantage of the cross or "+" shaped electrodes are not limited to COB cells. For example, as shown in Figure 8, a non-COB ¼ pitch cell 80 is shown, constructed using 0.4µm design rules and a 2µm² cell area. The underlying cell contacts are drawn with dashed perimeters 82 for the capacitor electrode contacts and dash-dot perimeters 83 for the bit line contacts. The cell area is 0.88µm² for each electrode and a 5.2µm perimeter. This compares well with the 0.96µm² electrode area and 4.4µm perimeters of a comparable COB cell with rectangular electrodes.

Although the invention has been described and illustrated with a certain degree of particularity, it will be understood that the present disclosure has been made only by way of example, and that numerous changes in the combination and arrangement of parts will be apparent to those skilled in the art without departing from the spirit and scope of the invention as hereinafter claimed.

## Claims

1. A capacitor for use as a part of a DRAM, comprising:
a semiconductor substrate in which said DRAM is constructed;
an insulation layer over said substrate;
a cross-shaped conductor over said insulation layer;
a dielectric layer over said cross-shaped conductor;
a substantially conformal conductor over said dielectric layer to form a capacitor with said cross-shaped conductor;
and a contact through said insulation layer from said DRAM to said cross-shaped conductor.

2. The capacitor of claim 1 wherein said cross-shaped conductor is about 0.2µm thick.

3. The capacitor of claim 1 wherein said cross-shaped conductor is about 0.2µm in thickness, 1.6µm in length, 1.6µm in width, and each arm of said cross-shaped electrode is about 0.4µm wide.

4. The capacitor of claim 1 further comprising a bit line in said insulation layer and a contact from said bitline to said DRAM.

5. A semiconductor memory cell, comprising:
a semiconductor substrate containing a memory cell; and
a memory capacitor having a cross-shaped capacitor electrode connected to said memory cell.

6. The memory cell of claim 5 wherein said cross-shaped capacitor electrode is about 0.2µm thick.

7. The memory cell of claim 5 wherein said cross-shaped electrode is about 0.2µm in thickness, 1.6µm in length, 1.6µm in width, and each arm of said cross-shaped electrode is about 0.4µm wide.

8. The memory cell of claim 5 wherein said cross-shaped electrode overlies a memory cell bit line.

9. A capacitor for use with a memory transistor in an integrated circuit memory, comprising:
a insulation layer on a semiconductor substrate containing said memory transistor;
a first capacitor electrode connected to said memory transistor and overlying said insulation layer, said first capacitor electrode having more than four lateral sides, said lateral sides contributing to a surface area of said first capacitor electrode;
a second capacitor electrode;
and a dielectric layer between said first and second capacitor electrodes to provide a capacitor for said memory transistor.

10. The capacitor of claim 9 wherein said first capacitor electrode is about 0.2µm thick.

11. The capacitor of claim 9 wherein said first capacitor electrode has at least two crossed members.

12. The capacitor of claim 9 wherein said first capacitor electrode has a shape like a "+" sign.

13. The capacitor of claim 9 wherein said first capacitor electrode is cross-shaped.

14. The capacitor of claim 13 wherein said cross-shaped electrode has four arms and wherein a thickness of one of said arms is greater than or equal to 50% of a width of said one of said arms.

15. The capacitor of claim 13 wherein said cross-shaped electrode is about 0.2µm in thickness, 1.6µm in length, 1.6µm in width, and each arm of said electrode is about 0.4µm wide.

16. A DRAM comprising:
a semiconductor substrate;
a memory transistor in said semiconductor substrate;
an insulation layer over said substrate;
a first capacitor electrode over said insulation layer connected to said memory transistor, said first capacitor electrode having more than four lateral sides, said lateral sides contributing to a surface area of said first capacitor electrode;
a second capacitor electrode;
and a dielectric layer between said first and second capacitor electrodes to provide a capacitor for said memory transistor.

17. The DRAM of claim 16 wherein said first capacitor electrode is has the shape of a "+" sign.

18. The DRAM of claim 16 wherein said first capacitor electrode is cross-shaped.

19. The DRAM of claim 18 wherein said cross-shaped capacitor electrode is about 0.2µm thick.

20. The DRAM of claim 16 wherein said cross-shaped electrode is about 0.2µm in thickness, 1.6µm in length, 1.6µm in width, and each arm of said cross-shaped electrode is about 0.4µm wide.

21. The DRAM of claim 16 wherein said capacitor for said memory transistor is located over a bit line for said DRAM.

22. A memory array, comprising:
a semiconductor substrate;
a plurality of memory cells in said substrate;
each memory cell including:
a memory transistor in said semiconductor substrate;
an insulation layer on said substrate;
a first capacitor electrode on said layer of insulation overlying said substrate and connected to said memory transistor, said first capacitor electrode having more than four lateral sides, said lateral sides contributing to a surface area of said capacitor electrode
a second capacitor electrode;
and a dielectric layer between said first and second capacitor electrodes to form a memory transistor therewith.

23. The memory array of claim 22 wherein said first capacitor electrode has the shape of a "+" sign.

24. The memory array of claim 22 wherein said first capacitor electrode is cross-shaped.

25. The memory array of claim 24 wherein said cross-shaped capacitor electrode is about 0.2µm thick.

26. The memory array of claim 24 wherein said cross-shaped electrode is about 0.2µm in thickness, 1.6µm in length, 1.6µm in width, and each arm of said cross-shaped electrode is about 0.4µm wide.

27. The memory array of claim 22 wherein said first capacitor is located over a bit line for said memory transistor.

28. The memory array of claim 22 wherein said memory cells are COB cells.

29. The capacitor of claim 22 wherein said memory cells are non-COB cells.

30. A method for making a capacitor electrode, comprising:
providing a mask having contiguous capacitor electrode features to be transferred to a positive photoresist layer in a semiconductor manufacturing process;
overexposing said positive photoresist layer using said mask, whereby said contiguous capacitor electrode features do not touch when said positive photoresist is developed.
